# EUROPEAN PATENT APPLICATION

(11) **EP 4 768 552 A1**
(43) Date of publication of application: **01.07.2026**
(21) Application number: 25225735.7
(22) Date of filing: 19.12.2025
(51) Int. Cl.: C09K 11/61, H05B 33/14

(54) **FLUORIDE PHOSPHOR AND LIGHT-EMITTING DEVICE**

(30) Priority: 26.12.2024 JP 2024230579
(71) Applicant: NICHIA CORPORATION, Tokushima 774-8601 (JP)
(72) Inventor: Yoshida, Tomokazu, Anan-shi, Tokushima 774-8601 (JP)
(74) Representative: Vossius & Partner Patentanwälte Rechtsanwälte mbB

(57) **Abstract**

A fluoride phosphor containing: manganese; fluorine; an element M including at least one selected from the group consisting of Group 4 elements, Group 13 elements, and Group 14 elements; and at least one selected from the group consisting of an alkali metal and an ammonium ion. When the total number of moles of the alkali metal and the ammonium ion is 2, the number of moles of the manganese is greater than 0 and less than 0.2, the total number of moles of the element M is greater than 0.8 and less than 1, and the number of moles of the fluorine is greater than 5 and less than 7. The fluoride phosphor has a particle diameter ratio (Da/Dm) that is 0.85 or greater, where Da is a mean particle diameter measured by a FSSS method, and Dm is a volume median diameter measured by a laser diffraction particle size distribution measurement method.

## Description

### CROSS-REFERENCE TO RELATED APPLICATION

This application claims priority to Japanese Patent Application No. 2024-230579, filed on December 26, 2024, the disclosure of which is hereby incorporated by reference in its entirety.

### TECHNICAL FIELD

The present disclosure relates to a fluoride phosphor and a light-emitting device.

### BACKGROUND

Various light-emitting devices in which a light-emitting element and a phosphor are combined have been developed and are being used in a wide range of fields such as in lighting, on-board lighting, displays, and liquid crystal backlights. For example, a phosphor used in a light-emitting device in a liquid crystal backlight application needs to have high color purity, that is, the full width at half maximum of the emission peak must be narrow. For example, Japanese Patent Publication No. 2012-224536 discloses, as a red luminous phosphor having a narrow full width at half maximum of the emission peak, a complex fluoride phosphor having a composition represented by K₂SiF₆:Mn.

### SUMMARY

In addition to a narrow full width at half maximum of the emission peak, phosphors used in light-emitting devices are also needed to have improved luminance. For example, the complex fluoride phosphor disclosed in the Japanese Patent Publication No. 2012-224536 has room for improvement in the luminance. Thus, an object of one aspect of the present disclosure is to provide a fluoride phosphor having high luminance.

A first aspect of the present disclosure relates to a fluoride phosphor containing an element M including manganese; fluorine; at least one selected from the group consisting of Group 4 elements, Group 13 elements, and Group 14 elements; and at least one selected from the group consisting of an alkali metal and an ammonium ion, wherein when the total number of moles of the alkali metal and the ammonium ion is set to 2, the number of moles of the manganese is greater than 0 and less than 0.2, the total number of moles of the element M is greater than 0.8 and less than 1, and the number of moles of the fluorine is greater than 5 and less than 7. The fluoride phosphor has a particle diameter ratio of a mean particle diameter Da to a volume median diameter Dm, *i.e.,* Da/Dm that is 0.85 or greater. The mean particle diameter Da is measured by a Fischer Sub-Sieve Sizer method. The volume median diameter Dm is measured by a laser diffraction particle size distribution measurement method.

A second aspect of the present disclosure relates to a method for manufacturing a fluoride phosphor, the method including providing fluoride particles having a specific composition, and heat-treating a mixture containing the fluoride particles thus provided, an alkali metal, and a liquid medium. The fluoride particles contain manganese, fluorine, an element M including at least one selected from the group consisting of Group 4 elements, Group 13 elements, and Group 14 elements, and at least one selected from the group consisting of an alkali metal and an ammonium ion, and when the total number of moles of the alkali metal and the ammonium ion is set to 2, the number of moles of the manganese is greater than 0 and less than 0.2, the total number of moles of the element M is greater than 0.8 and less than 1, and the number of moles of the fluorine is greater than 5 and less than 7.

According to one aspect of the present disclosure, a fluoride phosphor having high luminance can be provided.

### BRIEF DESCRIPTION OF DRAWINGS

FIG. 1 is a schematic cross-sectional view illustrating an example of a light-emitting device including a fluoride phosphor.
FIG. 2 is an example of a scanning electron microscope (SEM) image of a fluoride phosphor according to Example 1.
FIG. 3 is an example of a SEM image of a fluoride phosphor according to Comparative Example 1.

### DETAILED DESCRIPTION

In the present specification, unless otherwise specified, if a plurality of substances corresponding to a component are present in a composition, the content of the component in the composition means the total amount of the plurality of substances present in the composition. Furthermore, with respect to an upper limit and a lower limit of a numerical range described herein, the numerical values exemplified as the numerical range can be freely selected and combined. Note that herein, the relationship between a color name and chromaticity coordinates, the relationship between a wavelength range of light and a color name of monochromatic light are in accordance with JIS Z8110. The full width at half maximum of a phosphor means a wavelength width (full width at half maximum: FWHM) in an emission spectrum at which the emission intensity becomes 50% of the maximum emission intensity in the emission spectrum of the phosphor. The volume median diameter of a phosphor is the median diameter based on the volume, and refers to the particle diameter corresponding to a volume accumulation of 50% from the small diameter side in a particle size distribution based on the volume. The particle size distribution of the phosphor is measured by a laser diffraction method using a laser diffraction particle size distribution measuring device. In the present specification, a plurality of elements or ions separated by commas (,) in a formula representing the composition of the phosphor or light-emitting material means that at least one element or ion among the plurality of elements or ions is contained in the composition. In a formula representing the composition of the phosphor, any element preceding the colon (:) represents a host crystal, and any element following the colon (:) represents an activating element. Embodiments of the present invention are described below in detail. The embodiments presented below illustrate a fluoride phosphor and a light-emitting device that embody the technical concept of the present invention, but the present invention is not limited to the fluoride phosphor or the light-emitting device presented below.

### Fluoride Phosphor

The fluoride phosphor contains an element M including at least one selected from the group consisting of Group 4 elements, Group 13 elements, and Group 14 elements; at least one selected from the group consisting of an alkali metal and an ammonium ion; manganese; and fluorine. In the composition of the fluoride phosphor, when the total number of moles of the alkali metal and the ammonium ion is set to 2, the number of moles of the manganese may be in a range greater than 0 and less than 0.2, the total number of moles of the element M may be in a range greater than 0.8 and less than 1, and the number of moles of the fluorine may be in a range greater than 5 and less than 7. The fluoride phosphor may have a particle diameter ratio of a mean particle diameter Da to a volume median diameter Dm, that is Da/Dm of 0.85 or greater. The mean particle diameter Da is measured by a Fischer Sub-Sieve Sizer method (FSSS method). The volume median diameter Dm is measured by a laser diffraction particle size distribution measurement method. A fluoride phosphor having a particle diameter ratio (Da/Dm) of 0.85 or greater can exhibit high luminance.

The volume median diameter Dm is a particle diameter corresponding to a cumulative frequency of 50% from the small diameter side in a particle size distribution measured by a laser diffraction particle size distribution measurement method. The laser diffraction particle size distribution measurement method is a method for measuring the particle size distribution of particles by using scattered light of laser light applied to the particles. Therefore, when the particles to be measured include primary particles and secondary particles formed by aggregation of a plurality of primary particles, the particle size distribution is measured for the entire particle group without distinction between the primary particles and the secondary particles. That is, the volume median diameter Dm is a measured value of a particle group including primary particles and secondary particles. Meanwhile, the mean particle diameter Da measured by the FSSS method is a Fischer Sub-Sieve Sizer's Number. The FSSS method is a type of air permeation method, and is a method in which the flow resistance of air is utilized to measure the specific surface area. The FSSS method is a method mainly for determining the particle diameter of the primary particles.

The fluoride phosphor may be dispersed in a resin and used in the form of a resin composition in the manufacture of a light-emitting device. As the particle diameter ratio Da/Dm of the fluoride phosphor is closer to 1, in the particle group of the fluoride phosphor, the proportion of the secondary particles is lower, and the proportion of the primary particles is higher. As the proportion of the primary particles included in the fluoride phosphor particle group is higher, the dispersibility of the fluoride phosphor in the resin tends to be improved. Therefore, the particle diameter ratio Da/Dm can be used as an index indicating the dispersibility of the fluoride phosphor in the resin. The particle diameter of the fluoride phosphor contained in the resin composition used for manufacturing the light-emitting device may be limited by the volume median diameter Dm, which affects the fluidity in a dispensing means such as a syringe used for dispensing the resin composition. Meanwhile, the luminance of the fluoride phosphor tends to increase as the mean particle diameter Da, which is the particle diameter of the primary particles, is larger. Therefore, among fluoride phosphors having approximately the same volume median diameter Dm, a fluoride phosphor having a particle diameter ratio Da/Dm closer to 1 and a larger mean particle diameter Da tends to have higher luminance of the fluoride phosphor itself, and a light-emitting device to be manufactured therefrom tends to have a higher luminous flux.

The particle diameter ratio Da/Dm of the fluoride phosphor may be, for example, 0.85 or greater, and preferably 0.87 or greater, 0.90 or greater, 0.92 or greater, 0.94 or greater, or 0.97 or greater, from the viewpoint of improving the luminance of the fluoride phosphor. The particle diameter ratio Da/Dm is usually 1 or less. The particle diameter ratio Da/Dm of the fluoride phosphor can be set to a desired value, for example, depending on a method for manufacturing a fluoride phosphor described later.

The volume median diameter Dm of the fluoride phosphor may be, for example, in a range of 25 µm to 60 µm, preferably in a range of 28 µm to 55 µm, and more preferably in a range of 30 µm to 50 µm. When the fluoride phosphor has a volume median diameter Dm within the predetermined range and a particle diameter ratio Da/Dm of 0.85 or greater, in a case in which a composition containing a resin and the fluoride phosphor is potted in a formed body using a syringe to form a wavelength conversion member of a light-emitting device, the fluoride phosphor can be potted in a state in which the fluoride phosphor is dispersed in the resin without being clogged in the syringe. This can make it easier to manufacture the light-emitting device more efficiently. In addition, the obtained light-emitting device can have a higher luminous flux.

The mean particle diameter Da of the fluoride phosphor measured by the FSSS method may be, for example, in a range of 20 µm to 60 µm, preferably in a range of 23 µm to 55 µm, more preferably in a range of 25 µm to 50 µm, and may be 45 µm or less or 40 µm or less. When the mean particle diameter Da of the fluoride phosphor measured by the FSSS method is within the predetermined range and the particle diameter ratio Da/Dm is 0.85 or greater, the resin composition containing the fluoride phosphor and the resin can be potted in a state in which the fluoride phosphor is dispersed in the resin without being clogged in the syringe. This can make it easier to manufacture the light-emitting device more efficiently, and the obtained light-emitting device can have a higher luminous flux.

In the composition of the fluoride phosphor, when the total number of moles of the alkali metal and the ammonium ion is set to 2, the number of moles of Mn may be in a range greater than 0 and less than 0.2, and preferably in a range of 0.01 to 0.12. In the composition of the fluoride phosphor, when the total number of moles of the alkali metal and the ammonium ion is set to 2, the number of moles of the element M may be in a range greater than 0.8 and less than 1, and preferably in a range of 0.88 to 0.99. In the composition of the fluoride phosphor, when the number of moles of the alkali metal is set to 2, the number of moles of F may be in a range greater than 5 and less than 7, and preferably in a range of 5.9 to 6.1. The composition of the fluoride phosphor may be analyzed, for example, by X-ray fluorescence analysis or inductively coupled plasma (ICP) emission spectroscopy.

The alkali metal in the composition of the fluoride phosphor may include at least one selected from the group consisting of lithium (Li), sodium (Na), potassium (K), rubidium (Rb), and cesium (Cs). The alkali metal may include at least potassium (K), and at least one selected from the group consisting of lithium (Li), sodium (Na), rubidium (Rb), and cesium (Cs). The molar ratio of K to the total of the alkali metal and the ammonium ion in the composition may be, for example, 0.90 or greater, and is preferably 0.95 or greater, or 0.97 or greater. The molar ratio of K to the total of the alkali metal and the ammonium ion in the composition may be, for example, 1 or less, or 0.995 or less. The composition of the fluoride phosphor may contain an ammonium ion (NH₄⁺) instead of the alkali metal. When the composition contains an ammonium ion, the molar ratio of the ammonium ion to the total of the alkali metal and the ammonium ion in the composition may be, for example, 0.10 or less, and is preferably 0.05 or less, or 0.03 or less. The lower limit of the molar ratio of the ammonium ion to the total of the alkali metal and the ammonium ion in the composition may be, for example, greater than 0, and may be preferably 0.005 or greater. The alkali metal in the composition of the fluoride phosphor may be an alkali metal ion.

The element M in the composition of the fluoride phosphor includes at least one selected from the group consisting of Group 4 elements, Group 13 elements, and Group 14 elements. Examples of Group 4 elements include titanium (Ti), zirconium (Zr), and hafnium (Hf), and at least one selected from the group consisting of these elements may be included. Examples of Group 13 elements include boron (B), aluminum (Al), gallium (Ga), indium (In), and thallium (Tl), and at least one selected from the group consisting of these elements may be included. Examples of Group 14 elements include carbon (C), silicon (Si), germanium (Ge), and tin (Sn), and at least one selected from the group consisting of these elements may be included. In one aspect, the element M may at least include at least one of Group 14 elements, may preferably at least include at least one of Si and Ge, and may more preferably include at least Si. In one aspect, the element M may at least include at least one of Group 13 elements and at least one of Group 14 elements, may preferably at least include Al and at least one of Si and Ge, and may more preferably include at least Al and Si.

The manganese (Mn) in the composition of the fluoride phosphor may include a manganese ion, and may include at least a tetravalent manganese ion.

In the composition of the fluoride phosphor, the total number of moles of the elements M and Mn per a total of 2 moles of the alkali metal and the ammonium ion may be in a range of 0.9 to 1.1, preferably of 0.95 to 1.05, or of 0.97 to 1.03.

The composition of the fluoride phosphor may be a composition represented by Formula (1) below.

A_{c}[M_{1-b}Mn_{b}F_{d}] (1)

In Formula (1), A may include at least one selected from the group consisting of Li, Na, K, Rb, Cs, and NH₄⁺. M includes at least Si, and may further include at least one element selected from the group consisting of Group 4 elements, Group 13 elements, and Group 14 elements. Mn may be a tetravalent Mn ion. b may satisfy 0 < b < 0.2, c is the absolute value of the charge of the [M_{1-b}Mn_{b}F_{d}] ion, and d may satisfy 5 < d < 7.

A in Formula (1) includes at least K, and may further include at least one selected from the group consisting of Li, Na, Rb, Cs and NH₄⁺. The molar ratio of K to the total of A in the composition may be, for example, 0.90 or greater, preferably 0.95 or greater, or 0.97 or greater. The upper limit of the molar ratio of K to the total of A in the composition may be, for example, 1 or less, or 0.995 or less.

In Formula (1), b is preferably in a range of 0.005 to 0.15, or may be in a range of 0.01 to 0.12, or of 0.015 to 0.1. c may be in a range of 1.8 to 2.2, and is preferably in a range of 1.9 to 2.1, or of 1.95 to 2.05. d is preferably in a range of 5.5 to 6.5, and may be in a range of 5.9 to 6.1, of 5.95 to 6.05, or of 5.97 to 6.03.

The fluoride phosphor may have a theoretical composition represented by Formula (1a) below.

A₂MF₆:Mn (1a)

In Formula (1a), A may include at least one selected from the group consisting of Li, Na, K, Rb, Cs, and NH₄⁺. M includes at least Si, and may further include at least one element selected from the group consisting of Group 4 elements, Group 13 elements, and Group 14 elements. Mn may be a tetravalent Mn ion.

A first composition, which is one aspect of the composition of the fluoride phosphor, may contain, as the element M, at least one selected from the group consisting of Group 4 elements and Group 14 elements, may preferably contain at least one selected from the group consisting of Group 14 elements, may more preferably contain at least one of Si and Ge, and may even more preferably contain at least Si. In the first composition of the fluoride phosphor, the total number of moles of Si, Ge, and Mn per a total of 2 moles of the alkali metal and the ammonium ion may be in a range of 0.9 to 1.1, preferably of 0.95 to 1.05, or of 0.97 to 1.03.

The first composition of the fluoride phosphor may be a composition represented by Formula (2) below.

A¹_{q}[M¹₁₋ₚMnₚFᵣ] (2)

In Formula (2), A¹ may include at least one selected from the group consisting of Li, Na, K, Rb, Cs, and NH₄⁺+. M¹ includes at least one of Si and Ge, and may further include at least one element selected from the group consisting of Group 4 elements and Group 14 elements. Mn may be a tetravalent Mn ion. p may satisfy 0 < p < 0.2, q is the absolute value of the charge of the [M¹₁₋ₚMnₚFᵣ] ion, and r may satisfy 5 < r < 7.

A¹ in Formula (2) includes at least K, and may further include at least one selected from the group consisting of Li, Na, Rb, Cs, and NH₄⁺. When A¹ includes an ammonium ion, the molar ratio of the ammonium ion to the total A¹ in the composition may be, for example, 0.10 or less, and preferably may be 0.05 or less, or 0.03 or less. The lower limit of the molar ratio of the ammonium ion to the total A¹ in the composition may be, for example, greater than 0, and may be preferably 0.005 or greater.

In Formula (2), p is preferably in a range of 0.005 to 0.15, from 0.01 to 0.12, or from 0.015 to 0.1. q may be, for example, in a range of 1.8 to 2.2, and is preferably in a range of 1.9 to 2.1, or of 1.95 to 2.05. r is preferably in a range of 5.5 to 6.5, of 5.9 to 6.1, of 5.92 to 6.05, or of 5.95 to 6.025.

The fluoride phosphor having the first composition may have a first theoretical composition represented by Formula (2a) below.

A¹₂M¹F₆:Mn (2a)

In Formula (2a), A¹ may include at least one selected from the group consisting of Li, Na, K, Rb, Cs, and NH₄⁺. M¹ includes at least one of Si and Ge, and may further include at least one element selected from the group consisting of Group 4 elements and Group 14 elements. Mn may be a tetravalent Mn ion.

A second composition, which is one aspect of the composition of the fluoride phosphor, may contain, as the element M, at least one selected from the group consisting of Group 4 elements and Group 14 elements and at least one of Group 13 elements, may preferably contain at least one selected from the group consisting of Group 14 elements and at least one of Group 13 elements, and may more preferably contain at least Si and Al. In the second composition of the fluoride particles, the total number of moles of Si, Al, and Mn per a total of 2 moles of the alkali metal and the ammonium ion may be in a range of 0.9 to 1.1, preferably from 0.95 to 1.05, or from 0.97 to 1.03. In the second composition of the fluoride phosphor, the number of moles of Al per a total of 2 moles of the alkali metal and the ammonium ion may be in a range greater than 0 and 0.1 or less, and preferably in a range greater than 0 and 0.03 or less, in a range of 0.002 to 0.02, or of 0.003 to 0.015.

The second composition of the fluoride phosphor may be a composition represented by Formula (3) below.

A²ₜ[M²₁₋ₛMnₛFᵤ] (3)

In Formula (3), A² may include at least one selected from the group consisting of Li, Na, K, Rb, Cs, and NH₄⁺, preferably include at least K, and may further include at least one selected from the group consisting of Li, Na, Rb, Cs, and NH₄⁺. M² includes at least Si and Al, and may further include at least one element selected from the group consisting of Group 4 elements, Group 13 elements, and Group 14 elements. Mn may be a tetravalent Mn ion. s may satisfy 0 < s < 0.2, t is the absolute value of the charge of the [M²₁₋ₛMnₛFᵤ] ion, and u may satisfy 5 < u < 7.

When A² in Formula (3) includes an ammonium ion, the molar ratio of the ammonium ion to the total of A² in the composition may be, for example, 0.10 or less, and is preferably 0.05 or less, or 0.03 or less. The lower limit of the molar ratio of the ammonium ion to the total of A² in the composition may be, for example, greater than 0, and may be preferably 0.005 or greater.

In Formula (3), s is preferably in a range of 0.005 to 0.15, of 0.01 to 0.12, or of 0.015 to 0.1. t may be in a range of 1.8 to 2.2, and is preferably in a range of 1.9 to 2.1, or of 1.95 to 2.05. u is preferably in a range of 5.5 to 6.5, of 5.9 to 6.1, of 5.92 to 6.05, or of 5.95 to 6.025.

The fluoride phosphor having the second composition may have a second theoretical composition represented by Formula (3a) below.

A²₂Si₁₋ᵥAlᵥF₆₋ᵥ:Mn (3a)

In Formula (3a), A² may include at least one selected from the group consisting of Li, Na, K, Rb, Cs, and NH₄⁺, preferably include at least K, and may further include at least one selected from the group consisting of Li, Na, Rb, Cs, and NH₄⁺. v may satisfy 0 < v < 1, and preferably satisfies 0.005 < v < 0.03. Mn may be a tetravalent Mn ion.

The fluoride phosphor is, for example, a phosphor that is activated by tetravalent manganese, and the fluoride phosphor may absorb light of a short wavelength region of visible light and emit red light. Light with which the fluoride phosphor is irradiated may be primarily light in the blue region, and the peak wavelength of the light thereof may be, for example, within a wavelength range from 380 nm to 485 nm. The emission peak wavelength in the emission spectrum of the fluoride phosphor may be, for example, within a wavelength range from 610 nm to 650 nm. The full width at half maximum in the emission spectrum of the fluoride phosphor may be, for example, 10 nm or less.

### Method for Manufacturing Fluoride Phosphor

The method for manufacturing a fluoride phosphor includes a first step that is providing fluoride particles having a specific composition, and a second step that is heat-treating a mixture containing the provided fluoride particles and a treatment liquid containing an alkali metal and a liquid medium. Here, the fluoride particles having a specific composition contain: an element M including at least one selected from the group consisting of Group 4 elements, Group 13 elements, and Group 14 elements; at least one selected from the group consisting of an alkali metal and an ammonium ion; manganese; and fluorine, and when the total number of moles of the alkali metal and the ammonium ion is set to 2, the number of moles of the manganese may be in a range greater than 0 and less than 0.2, the total number of moles of the element M may be in a range greater than 0.8 and less than 1, and the number of moles of the fluorine may be in a range greater than 5 and less than 7. The alkali metal contained in the treatment liquid may include at least potassium.

When a mixture containing the fluoride particles having a specific composition and the treatment liquid containing an alkali metal and a liquid medium is heat-treated, a fluoride phosphor having a particle diameter ratio Da/Dm close to 1 can be efficiently manufactured. This is considered to be because, for example, when the fluoride particles are heat-treated in the liquid medium containing an alkali metal ion, recrystallization due to a dissolution and precipitation reaction of the fluoride particles is promoted, and the proportion of the primary particles in the fluoride particles is increased. The obtained fluoride phosphor has high luminance, and in a light-emitting device including a wavelength conversion member containing the fluoride phosphor and a resin, for example, the luminous flux is improved.

In the first step, fluoride particles having a specific composition are provided. In the first step, the fluoride particles may be purchased, or desired fluoride particles may be manufactured. The details of the composition of the fluoride particles to be provided are the same as those of the fluoride phosphor described above.

For example, the fluoride particles can be manufactured as follows. In a case in which the fluoride particles have the first composition, for example, the fluoride particles can be manufactured by a manufacturing method including a step of mixing a solution a with a solution b, the solution a containing at least hydrogen fluoride, a first complex ion including tetravalent manganese, and a second complex ion including a fluorine ion and at least one selected from the group consisting of Group 4 elements and Group 14 elements, and the solution b containing at least hydrogen fluoride and an alkali metal. Here, the alkali metal contained in the fluoride particles may include at least potassium.

The fluoride particles having the first composition can also be manufactured by a manufacturing method including a step of mixing a first solution, a second solution, and a third solution, the first solution containing at least hydrogen fluoride and a first complex ion including tetravalent manganese, the second solution containing at least hydrogen fluoride and an alkali metal, and the third solution containing at least a second complex ion including a fluorine ion and at least one selected from the group consisting of Group 4 elements and Group 14 elements. For the method for manufacturing the fluoride particles having the first composition, Japanese Patent Publication No. 2014-141684, Japanese Patent Publication No. 2015-143318, Japanese Patent Publication No. 2015-188075, and the like can be referenced, for example.

In a case in which the fluoride particles have the second composition, the fluoride particles having the second composition can be manufactured, for example, by a manufacturing method including: providing fluoride particles having the first composition; providing fluoride particles containing Al, an alkali metal, and F; and performing a first heat treatment step of subjecting a mixture of the fluoride particles having the first composition and the fluoride particles containing Al, an alkali metal, and F to a first heat treatment in an inert gas atmosphere at a first heat treatment temperature in a range of 600°C to 780°C. Here, the composition of the fluoride particles containing Al, an alkali metal, and F may be such that the ratio of the total number of moles of the alkali metal to 1 mole of Al is in a range of 1 to 3, and the ratio of the number of moles of F to 1 mole of Al is in a range of 4 to 6. Alternatively, the ratio of the total number of moles of the alkali metal to 1 mole of Al may be in a range of 2 to 3, and the ratio of the number of moles of F to 1 mole of Al may be in a range of 5 to 6. For the method for manufacturing the fluoride particles having the second composition, Japanese Patent Publication No. 2010-254933, Japanese Patent Publication No. 2022-099232, and the like can be referenced, for example. Here, the alkali metal contained in the fluoride particles may include at least potassium.

In the second step, a mixture containing the provided fluoride particles and the treatment liquid containing an alkali metal and a liquid medium is heat-treated. The alkali metal contained in the treatment liquid is the same as or a similar to the alkali metal contained in the composition of the fluoride particles, and the alkali metal contained in the treatment liquid and the alkali metal contained in the composition of the fluoride particles may be identical with each other. The alkali metal contained in the treatment liquid may be in the form of an alkali metal ion. Further, the alkali metal contained in the treatment liquid may include at least potassium. When the alkali metal contained in the treatment liquid includes potassium, the molar ratio of potassium to the total of the alkali metal in the treatment liquid may be, for example, 0.90 or greater, preferably 0.95 or greater or 0.97 or greater, and may be, for example, 1 or 0.995 or less. When the treatment liquid contains potassium, the potassium may be contained as an inorganic acid salt such as potassium hydrogen fluoride (KHF₂), potassium nitrate (KNO₃), or potassium fluoride (KF), or may be contained in a state in which the inorganic acid salt is dissolved in the liquid medium.

The content of the alkali metal in the treatment liquid may be, for example, in a range of 5 mass% to 30 mass%, preferably 10 mass% or greater, 12 mass% or greater, 15 mass% or greater, 18 mass% or greater, or 20 mass% or greater, and may be, for example, 28 mass% or less or 25 mass% or less.

The liquid medium is not particularly limited, and can be appropriately selected from usually used liquids according to the purpose and the like. Specific examples of the liquid medium include water; and alchol solvents including alcohol solvents such as methanol, ethanol, and isopropyl alcohol, ketone solvents such as acetone and methyl ethyl ketone, and ether solvents such as diethyl ether and diisopropyl ether. The liquid medium may be a substance that is a gas at normal pressure but is liquefied by pressurization, or a substance that is a solid at normal temperature but is liquefied by heating. The liquid medium preferably contains at least water, and may be substantially water. The liquid medium may be a single substance or a combination of two or more substances.

The treatment liquid may further contain a component soluble in the liquid medium. Examples of the component soluble in the liquid medium include inorganic acids such as hydrogen fluoride (HF), hexafluorosilicic acid (H₂SiF₆), and nitric acid (HNO₃); and peroxides such as hydrogen peroxide. The component soluble in the liquid medium may be used singly or a combination of two or more components may be used. The treatment liquid may contain at least hydrogen fluoride. When the treatment liquid contains hydrogen fluoride, the content of hydrogen fluoride in the treatment liquid may be, for example, in a range of 10 mass% to 80 mass%, preferably 20 mass% or greater, 40 mass% or greater, or 60 mass% or greater, and may be 75 mass% or less, 70 mass% or less, or 65 mass% or less.

The amount of the treatment liquid used in the mixture may be, as a mass percentage with respect to the fluoride particles, for example, in a range of 50 mass% to 500 mass%, preferably 80 mass% or greater, 85 mass% or greater, or 100 mass% or greater, and preferably 300 mass% or less, 200 mass% or less, or 150 mass% or less. When the mass percentage of the treatment liquid is within the above range, a fluoride phosphor having a higher proportion of primary particles tends to be manufactured.

The temperature of the heat treatment in the second step may be, for example, in a range of 150°C or greater to lower than 230°C. The heat treatment temperature may be preferably 160°C or higher, 170°C or higher, or 180°C or higher, and preferably 225°C or lower, or 220°C or lower. When the heat treatment temperature is 150°C or higher, recrystallization due to a dissolution and precipitation reaction of the fluoride phosphor proceeds more smoothly, and a fluoride phosphor having a high proportion of primary particles and a particle diameter ratio Da/Dm close to 1 can be obtained. When the heat treatment temperature is lower than 230°C, deterioration of the container used in the heat treatment can be inhibited.

The heat treatment time may be appropriately selected in accordance with treatment conditions such as the temperature. The heat treatment time may be, for example, in a range of 4 hours to 24 hours, preferably 8 hours or greater, 12 hours or greater, or 14 hours or greater, and 20 hours or less or 18 hours or less. When the heat treatment time is 4 hours or greater, a fluoride phosphor having a higher proportion of primary particles tends to be manufactured. A heat treatment time of 24 hours or less is advantageous from the viewpoint of production efficiency. The atmosphere in the heat treatment is not particularly limited, and may be an air atmosphere or an inert gas atmosphere.

In the heat treatment of the mixture, for example, the mixture may be placed in a pressure-resistant airtight container such as an autoclave and heated. The heat treatment using a pressure-resistant airtight container enables the mixture to be pressure- and heat-treated. That is, the heat treatment of the mixture in the second step may be a pressure and heat treatment of the mixture. The pressure-resistant airtight container may be a container formed of stainless steel or the like and having an inner surface coated with a fluororesin such as polytetrafluoroethylene (PTFE), or may be a container including a sample container formed of a fluororesin and an outer cylinder that encloses the sample container and can be subjected to pressure-resistant sealing.

The method for manufacturing a fluoride phosphor may further include, after the second step, a step of recovering the fluoride phosphor obtained in the second step by solid-liquid separation, a step of drying the fluoride phosphor obtained by solid-liquid separation, a step of dispersing the dried fluoride phosphor, and the like.

### Light-emitting Device

The light-emitting device may include a fluoride phosphor, and a light source having an emission peak wavelength in a wavelength range of 380 nm to 485 nm. The light-emitting device may further include other constituent members as necessary. The fluoride phosphor may constitute the light-emitting device in the form of a wavelength conversion member that contains, for example, the fluoride phosphor and a resin.

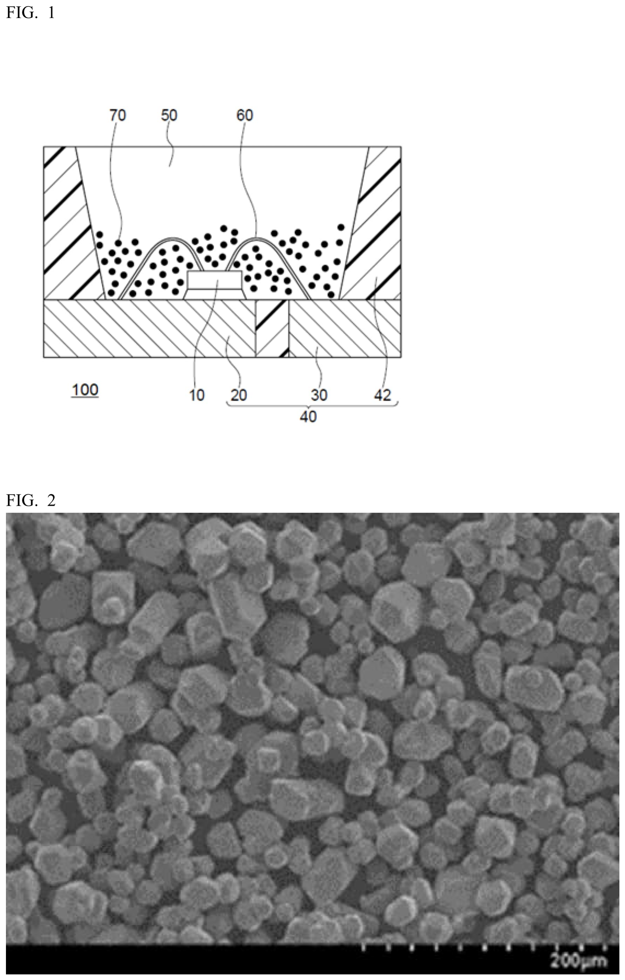

An example of the light-emitting device will be described with reference to the drawings. FIG. 1 is a schematic cross-sectional view illustrating one example of a light-emitting device according to the present embodiment. This light-emitting device is an example of a surface-mounted light-emitting device. A light-emitting device 100 includes a light-emitting element 10, which is a light source that emits light having an emission peak wavelength on the short-wavelength side of visible light (for example, in a range of 380 nm to 485 nm), and a formed body 40 in which the light-emitting element 10 is placed. The formed body 40 has a first lead 20 and a second lead 30, and is integrally formed using a thermoplastic resin or a thermosetting resin. A recessed portion defined by lateral surface(s) and a bottom surface corresponding to a substrate is formed in the formed body 40, and the light-emitting element 10 is placed on the bottom surface of the recessed portion. The light-emitting element 10 includes a pair of positive and negative electrodes, and the pair of positive and negative electrodes are electrically connected to the first lead 20 and the second lead 30 via wires 60. The light-emitting element 10 is covered with a wavelength conversion member 50. The wavelength conversion member 50 contains a phosphor 70 including a fluoride phosphor that converts the wavelength of light from the light-emitting element 10. The phosphor 70 includes the fluoride phosphor, and may further include a light-emitting material that, in response to excitation light from the light-emitting element 10, emits light having an emission peak wavelength in a wavelength range different from that of the fluoride phosphor.

The wavelength conversion member may contain a resin and a phosphor. Examples of the resin constituting the wavelength conversion member include a silicone resin, an epoxy resin, a modified silicone resin, a modified epoxy resin, and an acrylic resin. For example, the refractive index of a silicone resin may be in a range of 1.35 to 1.55, more preferably in a range of 1.38 to 1.43. The silicone resin having the refractive index within these ranges is highly transmissive to light, and can be suitably used as a resin constituting the wavelength conversion member. The refractive index of the silicone resin is the refractive index after curing, and is measured in accordance with JIS K 7142:2008. The wavelength conversion member may further include a light-diffusing material in addition to the resin and the phosphor. When a light-diffusing material is included, directivity from the light-emitting element can be broadened, and a viewing angle can be increased. Examples of the light-diffusing material include silicon oxide, titanium oxide, zinc oxide, zirconium oxide, and aluminum oxide.

The light-emitting element emits light having an emission peak wavelength in a wavelength range of 380 nm to 485 nm, which is a short wavelength region of visible light. The light-emitting element may be a light source that excites the fluoride phosphor. The light-emitting element preferably has an emission peak wavelength in a range of 380 nm to 480 nm, more preferably has an emission peak wavelength in a range of 410 nm to 480 nm, and even more preferably has an emission peak wavelength in a range of 430 nm to 480 nm. A semiconductor light-emitting element is preferably used as the light-emitting element of the light source. A stable light-emitting device that exhibits high efficiency and high output linearity with respect to an input and that is strong against mechanical impact can be obtained by using a semiconductor light-emitting element as the light source. As the semiconductor light-emitting element, for example, a semiconductor light-emitting element that uses a nitride-based semiconductor can be used. The full width at half maximum of the emission peak in the emission spectrum of the light-emitting element is preferably 30 nm or less, for example.

The light-emitting device includes a fluoride phosphor. Details of the fluoride phosphor included in the light-emitting device are described above. The fluoride phosphor is contained, for example, in the wavelength conversion member covering the light source. In the light-emitting device in which the light source is covered with the wavelength conversion member containing the fluoride phosphor, part of the light emitted from the light source is absorbed by the fluoride phosphor and emitted as red light. When a light source that emits light having an emission peak wavelength in the range of 380 nm to 485 nm is used, the emitted light can be utilized more efficiently, loss of light emitted from the light-emitting device can be reduced, and a highly efficient light-emitting device can be provided.

The light-emitting device preferably further includes, in addition to the fluoride phosphor, a light-emitting material other than the fluoride phosphor. The light-emitting material other than the fluoride phosphor may be any material that absorbs light from the light source and converts the light into light having a wavelength different from that of the fluoride phosphor. Like the fluoride phosphor, for example, the light-emitting material can be contained in the wavelength conversion member.

The light-emitting material may have an emission peak wavelength in a wavelength range of 495 nm to 573 nm, and may be preferably at least one selected from the group consisting of a β-sialon phosphor, a halosilicate phosphor, a silicate phosphor, a rare earth-aluminate phosphor, and a nitride phosphor. The β-sialon phosphor may have a composition represented by Formula (IIa) below, for example. The halosilicate phosphor may have a composition represented by Formula (IIb) below, for example. The silicate phosphor may have a composition represented by Formula (IIc) below, for example. The rare earth-aluminate phosphor may have a composition represented by Formula (IId) below. The nitride phosphor may have a composition represented by Formula (IIe), (IIf), or (IIg) below, for example. When the wavelength conversion member contains a β-sialon phosphor as the light-emitting material other than the fluoride phosphor, a light-emitting device that is used as, for example, a light source for a backlight can have a wider range of color reproducibility. When the wavelength conversion member contains, as the light-emitting material other than the fluoride phosphor, a halosilicate phosphor, a silicate phosphor, a rare earth-aluminate phosphor, or a nitride phosphor, a light-emitting device that is used as, for example, a light source for lighting can have higher color rendering properties or higher luminous efficiency.

Si₆₋ₓAlₓOₓN₈₋ₓ:Eu (IIa)

In Formula (IIa), x is a number satisfying 0 < x ≤ 4.2

(Ca, Sr, Ba)₈MgSi₄O₁₆(F, Cl, Br)₂:Eu (IIb)

(Ba, Sr, Ca, Mg)₂SiO₄:Eu (IIc)

(Y, Lu, Gd, Tb)₃(Al, Ga)₅O₁₂:Ce (IId)

(La, Y, Gd)₃Si₆N₁₁:Ce (IIe)

(Sr, Ca)LiAl₃N₄:Eu (IIf)

(Ca, Sr)AlSiN₃:Eu (IIg)

The wavelength conversion member may further contain at least one type of quantum dot in addition to the fluoride phosphor. The quantum dots may be quantum dots that absorb light from the light source and convert the light to light of a wavelength differing from that of the fluoride phosphor, or may be quantum dots that convert the absorbed light to light of approximately the same wavelength. Examples of quantum dots include quantum dots having a perovskite structure with a composition such as (Cs, FA, MA)(Pb, Sn)(Cl, Br, I)₃ (where FA denotes formamidinium and MA denotes methylammonium), quantum dots having a chalcopyrite structure with a composition such as (Ag, Cu, Au)(In, Ga)(S, Se, Te)₂, semiconductor quantum dots such as (Cd, Zn)(Se, S), and InP-based semiconductor quantum dots. The quantum dots may include at least one type selected from the group consisting of these. When the wavelength conversion member contains quantum dots as the light-emitting material other than the fluoride phosphor, a light-emitting device that is used as, for example, a light source for a backlight can have a wider range of color reproducibility.

The invention according to the present disclosure may encompass the following clauses.

### [Clause 1]

A fluoride phosphor comprising:
an element M including at least one selected from the group consisting of Group 4 elements, Group 13 elements, and Group 14 elements;
at least one selected from the group consisting of an alkali metal and an ammonium ion;
manganese; and
fluorine, wherein
when a total number of moles of the alkali metal and the ammonium ion is set to 2, a number of moles of the manganese is in a range greater than 0 and less than 0.2, a total number of moles of the element M is in a range greater than 0.8 and less than 1, and a number of moles of the fluorine is in a range greater than 5 and less than 7, and
the fluoride phosphor has a particle diameter ratio of a mean particle diameter Da to a volume median diameter Dm, that is Da/Dm of 0.85 or greater, where the mean particle diameter Da is measured by a Fischer Sub-Sieve Sizer method, and the volume median diameter Dm is measured by a laser diffraction particle size distribution measurement method.

### [Clause 2]

The fluoride phosphor according to clause 1, wherein the fluoride phosphor has a composition represented by Formula (1) below:

A_{c}[M_{1-b}Mn_{b}F_{d}] (1)

(in Formula (1), A includes at least one selected from the group consisting of Li, Na, K, Rb, Cs, and NH₄⁺; M includes at least one element selected from the group consisting of Group 4 elements, Group 13 elements, and Group 14 elements, and includes at least Si; b satisfies 0 < b < 0.2, c is an absolute value of a charge of the [M_{1-b}Mn_{b}F_{d}] ion, and d satisfies 5 < d < 7).

### [Clause 3]

The fluoride phosphor according to clause 1 or 2, wherein the fluoride phosphor has a mean particle diameter Da in a range of 20 µm to 60 µm measured by the Fischer Sub-Sieve Sizer method.

### [Clause 4]

A light-emitting device comprising:
the fluoride phosphor described in any one of clauses 1 to 3; and
a light source having an emission peak wavelength in a wavelength range of 380 nm to 485 nm.

### [Clause 5]

The light-emitting device according to clause 4, further comprising a light-emitting material having an emission peak wavelength in a wavelength range of 495 nm to 573 nm.

### [Clause 6]

A method for manufacturing a fluoride phosphor, the method comprising:
providing fluoride particles having a specific composition comprising,
   an element M including at least one selected from the group consisting of Group 4 elements, Group 13 elements, and Group 14 elements;
   at least one selected from the group consisting of an alkali metal and an ammonium ion;
   manganese; and
   fluorine, wherein
   when a total number of moles of the alkali metal and the ammonium ion is set to 2, a number of moles of the manganese is in a range greater than 0 and less than 0.2, a total number of moles of the element M is in a range greater than 0.8 and less than 1, and a number of moles of the fluorine is in a range greater than 5 and less than 7, and
heat-treating a mixture containing the provided fluoride particles and a treatment liquid containing an alkali metal and a liquid medium.

### [Clause 7]

The method for manufacturing a fluoride phosphor according to clause 6, wherein a content of the alkali metal in the treatment liquid is 10 mass% or greater.

### [Clause 8]

The method for manufacturing a fluoride phosphor according to clause 6 or 7, wherein the treatment liquid further contains hydrogen fluoride.

### [Clause 9]

The method for manufacturing a fluoride phosphor according to clause 8, wherein a content of the hydrogen fluoride in the treatment liquid is 40 mass% or greater.

### [Clause 10]

The method for manufacturing a fluoride phosphor according to any one of clauses 6 to 9, wherein a temperature of the heat treatment is 180° C or higher.

### Examples

Hereinafter, embodiments according to the present disclosure will be specifically described with reference to examples, but the embodiments of the present disclosure are not limited to these examples.

### Manufacturing Example 1

KHF₂ was weighed in an amount of 7029 g, and the KHF₂ was dissolved in 37.3 L of a 55 mass% aqueous hydrogen fluoride (HF) solution to prepare a first solution. Further, K₂MnF₆ was weighed in an amount of 314.2 g, and the K₂MnF₆ was dissolved in 6.0 L of a 55 mass% aqueous HF solution to prepare a second solution. Subsequently, 7.8 L of an aqueous solution containing 40 mass% of H₂SiF₆ was prepared and used as a third solution. Subsequently, the first solution was stirred at 20°C while the second and third solutions were added dropwise over a period of about 10 hours. After completion of the dropwise addition, 400 mL of a 35% hydrogen peroxide solution was added, washing was performed with pure water, and the resultant precipitates were subjected to solid-liquid separation and then ethanol washing was performed, and drying was performed at 90°C for 10 hours. In this way, fluoride particles P1 of Manufacturing Example 1 were manufactured.

The resultant fluoride particles P1 had a mean particle diameter of Da = 20.5 µm, and had a composition represented by K₂[Si_{0.961}Mn_{0.039}F₆].

### Manufacturing Example 2

Fluoride particles P2 of Manufacturing Example 2 were manufactured by the same as or similar method as in Manufacturing Example 1 except that KHF₂ was weighed in an amount of 7029 g and the KHF₂ was dissolved in 41.3 L of a 55 mass% aqueous HF solution to form a first solution, and that K₂MnF₆ was weighed in an amount of 333.8 g and the K₂MnF₆ was dissolved in 6.0 L of a 55 mass% aqueous HF solution to prepare a second solution.

The resultant fluoride particles P2 had a mean particle diameter of Da = 40.0 µm, and had a composition represented by K₂[Si_{0.963}Mn_{0.037}F₆].

### Manufacturing Example 3

Fluoride particles P3 of Manufacturing Example 3 were manufactured by the same as or a similar method as in Manufacturing Example 1 except that KHF₂ was weighed in an amount of 7029 g and the KHF₂ was dissolved in 42.0 L of a 55 mass% aqueous HF solution to form a first solution, and that K₂MnF₆ was weighed in an amount of 340.4 g and the K₂MnF₆ was dissolved in 6.0 L of a 55 mass% aqueous HF solution to prepare a second solution.

The resultant fluoride particles P3 had a mean particle diameter of Da = 50.0 µm, and had a composition represented by K₂[Si_{0.962}Mn_{0.038}F₆].

### Manufacturing Example 4

Fluoride particles P4 of Manufacturing Example 4 were manufactured by the same as or a similar method as in Manufacturing Example 1 except that KHF₂ was weighed in an amount of 7029 g and the KHF₂ was dissolved in 36.5 L of a 55 mass% aqueous HF solution to form a first solution, and that K₂MnF₆ was weighed in an amount of 484.4 g and the K₂MnF₆ was dissolved in 6.0 L of a 55 mass% aqueous HF solution to prepare a second solution.

The resultant fluoride particles P4 had a mean particle diameter of Da = 18.5 µm, and had a composition represented by K₂[Si_{0.941}Mn_{0.059}F₆].

### Manufacturing Example 5

Fluoride particles P5 of Manufacturing Example 5 were manufactured by the same as or a similar method as in Manufacturing Example 1 except that KHF₂ was weighed in an amount of 7029 g and the KHF₂ was dissolved in 40.0 L of a 55 mass% aqueous HF solution to form a first solution, and that K₂MnF₆ was weighed in an amount of 497.5 g and the K₂MnF₆ was dissolved in 6.0 L of a 55 mass% aqueous HF solution to prepare a second solution.

The resultant fluoride particles P5 had a mean particle diameter of Da = 31.5 µm, and had a composition represented by K₂[Si_{0.944}Mn_{0.056}F₆].

### Example 1

The fluoride particles P1 manufactured in Manufacturing Example 1 were weighed in an amount of 50 g and placed in a PTFE sample container (HUT-100R available from SAN-AI Kagaku Co., Ltd.) having an internal volume of 100 mL. Subsequently, 75 g of a treatment liquid (potassium concentration: 20 mass%) prepared by dissolving 30 g of KHF₂ in 45 g of a 65 mass% aqueous HF solution was added, the components were stirred to form a slurry, and then the resulting mixture was covered with a lid. The sample container with the lid was set in a stainless steel outer cylinder (HUS-100 available from SAN-AI Kagaku Co., Ltd.), and the mixture was heat-treated in a constant-temperature equipment at 190°C for 16 hours.

After completion of the heat treatment, the PTFE sample container was taken out from the stainless steel outer cylinder, the resultant precipitates in the sample container were transferred to a beaker, and 600 mL of a 1% hydrogen peroxide solution was added to perform washing. After solid-liquid separation, ethanol washing was performed, and drying was performed at 90°C for 10 hours. After completion of the drying, a wet dispersion treatment using polyethylene beads was performed for 1 hour. After solid-liquid separation, washing was performed with a hydrogen peroxide solution and ethanol, and drying was performed at 90°C for 10 hours to produce a fluoride phosphor of Example 1.

### Example 2

A fluoride phosphor of Example 2 was produced by the same as or a similar method as in Example 1 except that the fluoride particles P2 manufactured in Manufacturing Example 2 were used.

### Example 3

A fluoride phosphor of Example 3 was produced by the same as or a similar method as in Example 1 except that the fluoride particles P3 manufactured in Manufacturing Example 3 were used.

### Example 4

A fluoride phosphor of Example 4 was produced by the same as or a similar method as in Example 1 except that the fluoride particles P4 manufactured in Manufacturing Example 4 were used.

### Example 5

A fluoride phosphor of Example 5 was produced by the same as or a similar method as in Example 5 except that the fluoride particles P5 manufactured in Manufacturing Example 5 were used.

### Example 6

A fluoride phosphor of Example 6 was produced by the same as or a similar method as in Example 2 except that the treatment liquid used in the heat treatment was changed to a treatment liquid (potassium concentration: 25 mass%) prepared by dissolving 37.5 g of KHF₂ in 37.5 g of a 65 mass% aqueous HF solution.

### Example 7

A fluoride phosphor of Example 7 was produced by the same as or a similar method as in Example 1 except that the treatment liquid used in the heat treatment was changed to a treatment liquid (potassium concentration: 10 mass%) prepared by dissolving 15 g of KHF₂ in 60 g of a 65 mass% aqueous HF solution.

### Comparative Example 1

The fluoride particles P1 manufactured in Manufacturing Example 1 were subjected to a wet dispersion treatment using polyethylene beads for 1 hour in the same manner as in Example 1. After solid-liquid separation, washing was performed with a hydrogen peroxide solution and ethanol, and drying was performed at 90°C for 10 hours to produce a fluoride phosphor of Comparative Example 1.

### Comparative Example 2

A fluoride phosphor of Comparative Example 2 was produced by the same as or a similar method as in Comparative Example 1 except that the fluoride particles P2 manufactured in Manufacturing Example 2 were used.

### Comparative Example 3

A fluoride phosphor of Comparative Example 3 was produced by the same as or a similar method as in Comparative Example 1 except that the fluoride particles P3 manufactured in Manufacturing Example 3 were used.

### Comparative Example 4

The fluoride particles P1 manufactured in Manufacturing Example 1 were subjected to a heat treatment at a temperature of 500°C for a dwell time of 8 hours in an atmosphere having a fluorine gas (F₂) concentration of 20 vol% and a nitrogen gas concentration of 80 vol% while the fluoride particles P1 were in contact with a fluorine gas. Subsequently, a wet dispersion treatment using polyethylene beads was performed for 1 hour. After solid-liquid separation, washing was performed with a hydrogen peroxide solution and ethanol, and drying was performed at 90°C for 10 hours to produce a fluoride phosphor of Comparative Example 4.

### Comparative Example 5

A fluoride phosphor of Comparative Example 5 was produced by the same as or a similar method as in Example 1 except that the treatment liquid used in the heat treatment was changed to a treatment liquid (potassium concentration: 9 mass%) prepared by dissolving 10 g of KHF₂ in 45 g of a 65 mass% aqueous HF solution.

### Evaluation

Each of the fluoride phosphors obtained above was evaluated as follows. The results are presented in Table 1 below.

### 1. Mean Particle Diameter Da

The mean particle diameter Da was measured by the FSSS method using Fisher Sub-Sieve Sizer Model 95 (available from Fisher Scientific).

### 2. Volume Median Diameter Dm

Using a laser diffraction particle size distribution measuring device (product name: MASTER SIZER 3000 available from Malvern Panalytical Ltd.), the volume median diameter Dm was measured as a particle diameter at which the volume cumulative frequency from the small diameter side reached 50%.

### 3. Emission Spectrum and Relative Luminance

Using a spectrofluorometer (product name: QE-2000 available from Otsuka Electronics Co., Ltd.), each of the fluoride phosphors was irradiated with excitation light having an emission peak wavelength of 450 nm, and the emission spectrum of each of the fluoride phosphors at room temperature (25°C) was measured.

Using the data of the measured emission spectrum, the luminance of the fluoride phosphors other than that of Comparative Example 1 was determined as the relative luminance with the luminance of the fluoride phosphor of Comparative Example 1 taken as 100%.

### 4. Amount of Mn (Variable b)

The content of Mn was measured by X-ray fluorescence analysis using an X-ray fluorescence analyzer (XRF; product name: ZSX Primus II manufactured by Rigaku Corporation), and the ratio of the number of moles of Mn (variable b) to 1 mole of the composition represented by Formula (I) was determined.

### 5. SEM Image

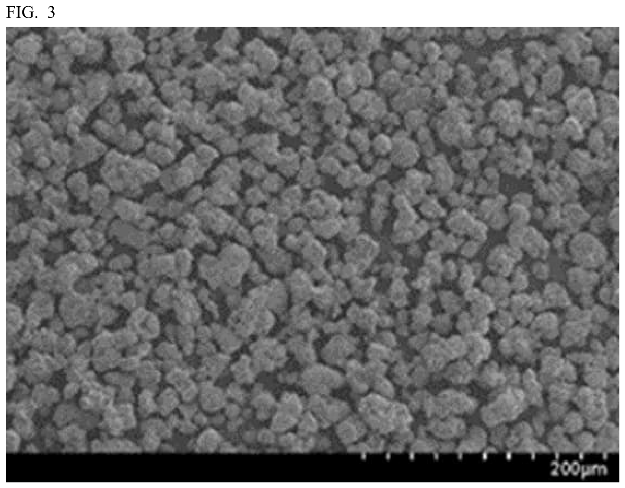

A scanning electron microscope (SEM) was used to obtain SEM images of the fluoride phosphors. FIG. 2 provides a SEM image of Example 1, and FIG. 3 provides a SEM image of Comparative Example 1.

**[Table 1]**

| | Mixture | | | | | FSSS mean particle diameter Da (µm) | Volume median diameter Dm (µm) | Particle diameter ratio Da/Dm | **Relative** luminance (%) | Amount of Mn (b) |
|---|---|---|---|---|---|---|---|---|---|---|
| | Fluoride Particles | | 65% Aqueous HF solution (9) | KHF₂ (9) | Potassium concentration (mass%) | | | | | |
| | Type | Amount added (9) | | | | | | | | |
| Example 1 | P1 | 50 | 45.0 | 30.0 | 20 | 31.5 | 32.7 | 0.96 | 114.7 | 0.035 |
| Example 2 | P2 | 50 | 45.0 | 30.0 | 20 | 38.0 | 37.5 | 1.01 | 120.3 | 0.034 |
| Example 3 | P3 | 50 | 45.0 | 30.0 | 20 | 44.5 | 43.9 | 1.01 | 121.6 | 0.035 |
| Example 4 | P4 | 50 | 45.0 | 30.0 | 20 | 29.5 | 32.1 | 0.92 | 122.1 | 0.052 |
| Example 5 | P5 | 50 | 45.0 | 30.0 | 20 | 34.0 | 34.4 | 0.99 | 123.9 | 0.051 |
| Example 6 | P1 | 50 | 37.5 | 37.5 | 25 | 38.0 | 37.7 | 1.01 | 121.1 | 0.036 |
| Example 7 | P1 | 50 | 60.0 | 15.0 | 10 | 27.5 | 31.4 | 0.88 | 107.7 | 0.027 |
| Comparative Example 1 | P1 | - | - | - | - | 17.0 | 26.9 | 0.63 | 100.0 | 0.039 |
| Comparative Example 2 | P2 | - | - | - | - | 24.5 | 31.8 | 0.77 | 105.4 | 0.037 |
| Comparative Example 3 | P3 | - | - | - | - | 27.5 | 33.8 | 0.81 | 110.8 | 0.038 |
| Comparative Example 4 | P1 | - | - | - | - | 16.5 | 26.4 | 0.63 | 103.1 | 0.039 |
| Comparative Example 5 | P1 | 50 | 45.0 | 10.0 | 9 | 25.0 | 31.0 | 0.81 | 108.0 | 0.029 |

As shown in Table 1, the fluoride phosphors of Examples 1 to 6 had higher relative luminance than the fluoride phosphors of the comparative examples. In addition, the particle diameter ratio Da/Dm of the fluoride phosphors of the examples is closer to 1, and therefore, it is found that the fluoride phosphors have further improved dispersibility.

### Reference Signs List

10: Light-emitting element, 20: First lead, 30: Second lead, 40: Formed body, 50: Wavelength conversion member, 60: Wire, 70: Phosphor, 100: Light-emitting device

It is to be understood that although the present invention has been described with regard to preferred embodiments thereof, various other embodiments and variants may occur to those skilled in the art, which are within the scope and spirit of the invention, and such other embodiments and variants are intended to be covered by the following claims.

Although the present disclosure has been described with reference to several exemplary embodiments, it is to be understood that the words that have been used are words of description and illustration, rather than words of limitation. Changes may be made within the purview of the appended claims, as presently stated and as amended, without departing from the scope and spirit of the disclosure in its aspects. Although the disclosure has been described with reference to particular examples, means, and embodiments, the disclosure may be not intended to be limited to the particulars disclosed; rather the disclosure extends to all functionally equivalent structures, methods, and uses such as are within the scope of the appended claims.

One or more examples or embodiments of the disclosure may be referred to herein, individually and/or collectively, by the term "disclosure" merely for convenience and without intending to voluntarily limit the scope of this application to any particular disclosure or inventive concept. Moreover, although specific examples and embodiments have been illustrated and described herein, it should be appreciated that any subsequent arrangement designed to achieve the same or similar purpose may be substituted for the specific examples or embodiments shown. This disclosure may be intended to cover any and all subsequent adaptations or variations of various examples and embodiments. Combinations of the above examples and embodiments, and other examples and embodiments not specifically described herein, will be apparent to those of skill in the art upon reviewing the description.

In addition, in the foregoing Detailed Description, various features may be grouped together or described in a single embodiment for the purpose of streamlining the disclosure. This disclosure may be not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The above disclosed subject matter shall be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure may be determined by the broadest permissible interpretation of the following claims and their equivalents, and shall not be restricted or limited by the foregoing detailed description.

All publications, patent applications, and technical standards mentioned in this specification are herein incorporated by reference to the same extent as if each individual publication, patent application, or technical standard was specifically and individually indicated to be incorporated by reference.

## Claims

1. A fluoride phosphor comprising:
an element M including at least one selected from the group consisting of Group 4 elements, Group 13 elements, and Group 14 elements;
at least one selected from the group consisting of an alkali metal and an ammonium ion;
manganese; and
fluorine, wherein
when a total number of moles of the alkali metal and the ammonium ion is set to 2, a number of moles of the manganese is greater than 0 and less than 0.2, a total number of moles of the element M is greater than 0.8 and less than 1, and a number of moles of the fluorine is greater than 5 and less than 7, and
the fluoride phosphor has a particle diameter ratio Da/Dm that is 0.85 or greater, where Da is a mean particle diameter measured by a Fischer Sub-Sieve Sizer method, and Dm is a volume median diameter measured by a laser diffraction particle size distribution measurement method.

2. The fluoride phosphor according to claim 1, wherein the fluoride phosphor has a composition represented by Formula (1) below:
A_{c}[M_{1-b}Mn_{b}F_{d}] (1),
wherein in Formula (1), A includes at least one selected from the group consisting of Li, Na, K, Rb, Cs, and NH₄⁺; M includes at least one element selected from the group consisting of Group 4 elements, Group 13 elements, and Group 14 elements, and includes at least Si; b satisfies 0 < b < 0.2, c is an absolute value of a charge of the [M_{1-b}Mn_{b}F_{d}] ion, and d satisfies 5 < d < 7.

3. The fluoride phosphor according to claim 1 or 2, wherein the mean particle diameter Da of the fluoride phosphor is in a range of 20 µm to 60 µm.

4. A light-emitting device comprising:
the fluoride phosphor described in any one of claims 1 to 3; and
a light source having an emission peak wavelength in a range of 380 nm to 485 nm.

5. The light-emitting device according to claim 4, further comprising a light-emitting material having an emission peak wavelength in a range of 495 nm to 573 nm.
